# EUROPÄISCHE PATENTANMELDUNG

(11) **EP 1 306 144 A1**
(43) Veröffentlichungstag der Anmeldung: **02.05.2003**
(21) Anmeldenummer: 01811036.1
(22) Anmeldetag: 23.10.2001
(51) Int. Cl.: B21C 29/00

(54) **Verfahren zur kontinuierlichen Oberflächenbehandlung eines Aluminiumprofils**

(71) Anmelder: Alcan Technology & Management AG, 8212 Neuhausen am Rheinfall (CH)
(72) Erfinder: Paulet, Jean-Francois, 8261 Hemishofen (CH)

(57) **Zusammenfassung**

Bei einem Verfahren zur kontinuierlichen Behandlung der Oberfläche eines durch Verpressen eines vorgewärmten Bolzens (17) aus Aluminium oder aus einer Aluminiumlegierung durch die Matrizenöffnung (24) einer Strangpresse (10) hergestellten Profils (20) wird zur Erzeugung einer als temporärer Korrosionsschutz und/oder als Haftgrund für weitere Beschichtungen dienenden Schicht nach dem Austritt des Profils (20) aus der Matrizenöffnung (24) wenigstens ein Stoff in gasförmigem Zustand oder in der Form eines Aerosols zur Reaktion auf und/oder mit der Profiloberfläche unter Bildung der Schicht auf die heisse, reaktive Profiloberfläche geleitet.

Das Verfahren ermöglicht auf einfache Weise die Oberflächenbehandlung eines Profils in Linie mit der Herstellung des Profils.

## Beschreibung

Die Erfindung betrifft ein Verfahren zur kontinuierlichen Behandlung der Oberfläche eines durch Verpressen eines vorgewärmten Bolzens aus Aluminium oder aus einer Aluminiumlegierung durch die Matrizenöffnung einer Strangpresse hergestellten Profils.

Bei der Herstellung von Aluminiumprofilen durch Strangpressen werden vorgewärmte Bolzen in einen auf Presstemperatur vorgeheizten Rezipienten eingeführt. Mittels eines Pressstempels wird der Bolzen zur Erzeugung eines Profils mit einer gewünschten Querschnittsform durch eine Matrize mit entsprechend geformter Öffnung gepresst.

Am Matrizenausgang ist die Profiltemperatur hoch und demzufolge die Aluminiumoberfläche äusserst reaktiv. Nach dem Austritt aus der Matrize reagiert daher das Aluminium an der Profiloberfläche sofort mit dem Sauerstoff der Umgebung, und es bildet sich eine sogenannte "natürliche" Oxidschicht aus. Diese Schicht ist zwar kompakt, aber nur sehr dünn ausgebildet. Deshalb ist ihre Schutzfunktion stark eingeschränkt und kann nicht als Haftgrund für eine weitere Beschichtung dienen.

In der bisherigen Praxis erfolgt die Oberflächenbehandlung von Aluminiumprofilen am gepressten und abgekühlten Profil in einem oder mehreren separaten Arbeitsgängen. Hierzu gehören beispielsweise chemische und/oder elektrolytische Verfahren zum Entfetten, zum Beizen sowie zum Aufbau einer geeigneten Beschichtung.

Der Erfindung liegt die Aufgabe zugrunde, eine Verfahren der eingangs genannten Art bereitzustellen, mit welchem eine Schutzschicht auf der Profiloberfläche auf einfache und kostengünstige Weise hergestellt werden kann.

Zur erfindungsgemässen Lösung der Aufgabe führt, dass zur Erzeugung einer als temporärer Korrosionsschutz und/oder als Haftgrund für weitere Beschichtungen dienenden Schicht nach dem Austritt des Profils aus der Matrizenöffnung wenigstens ein Stoff in gasförmigem Zustand oder in der Form eines Aerosols zur Reaktion auf und/oder mit der Profiloberfläche unter Bildung der Schicht auf die heisse, reaktive Profiloberfläche geleitet wird.

Die erfindungswesentliche Idee, die Oberflächenbehandlung eines Aluminiumprofils direkt während dem Strangpressvorgang an dem aus der Matrizenöffnung austretenden Profil durchzuführen, macht sich die zu diesem Zeitpunkt auf der Profiloberfläche für chemische Reaktionen auf und/oder mit der frisch erzeugten Aluminiumoberfläche vorherrschenden günstigen Bedingungen zunutze. Hierzu gehören die hohe Temperatur beim Austritt des Profils aus der Matrizenöffnung und die hohe Reaktivität des Aluminiums an der frisch gebildeten Profiloberfläche im Stadium der sich durch Reaktion mit dem Sauerstoff der Umgebungsatmosphäre ausbildenden dünnen Oxidschicht.

Durch die Verwendung geeigneter Reagenzien kann die sich auf der Profiloberfläche ausbildende Oberflächenschicht auf einfache Weise modifiziert werden, wodurch die Bildung einer temporären Korrosionsschutzschicht und/oder einer Haftgrundschicht in Linie mit der Profilherstellung möglich wird.

Die Ausbildung der Schicht auf der Profiloberfläche kann durch die Reaktion der auf die Profiloberfläche geleiteten Stoffe in Form einer Zersetzungsreaktion oder einer Reaktion zwischen zwei oder mehr Stoffen bei der auf der Profiloberfläche herrschenden hohen Temperatur erfolgen. Möglich ist jedoch auch die Reaktion der Stoffe mit der Profiloberfläche unter Einbezug der auf der frischen Aluminiumoberfläche mit Sauerstoff eintretenden Oxidationsreaktion.

Eine wesentliche Voraussetzung bei der Durchführung des erfindungsgemässen Verfahrens ist die Einhaltung einer hohen Temperatur an der Profiloberfläche während der Zuleitung der Reagenzien. Bevorzugt werden die Stoffe unmittelbar nach dem Austritt des Profils aus der Matrizenöffnung auf die Profiloberfläche geleitet. In gewissen Fällen ist es auch möglich und ggf. sogar vorteilhaft, die erfindungsgemässe Oberflächenbehandlung zusammen mit einem allfälligen Abschrecken des Profils durchzuführen. Hierbei sollte darauf geachtet werden, dass die Stoffe bei einer Profiltemperatur, die zwischen der Austrittstemperatur an der Matrizenöffnung und einer Temperatur, die nicht tiefer als 350°C, vorzugsweise nicht tiefer als 450°C, liegt, auf die Profiloberfläche geleitet werden.

Die chemische Reaktion der auf die Profiloberfläche geleiteten Stoffe in der Form von Gasen, Aerosolen und Dämpfen zur Bildung der Schicht erfolgt bei Atmosphärendruck. Zusammenfassend setzt sich der Beschichtungsvorgang aus den folgenden Schritten zusammen:
- Prozessgase werden über die heisse Profiloberfläche im Bereich der Matrizenöffnung geleitet
- Die Prozessgase reagieren auf und/oder mit der heissen Aluminiumoberfläche
- Auf der Profiloberfläche wird durch die chemische Reaktion eine Schicht erzeugt.

Als mögliche Stoffe bzw. Reagenzien bietet sich eine Vielzahl von Stoffen und Stoffgemischen an.

Bevorzugte Stoffe in gasförmigem Zustand umfassen beispielsweise Wasserdampf als Basis mit Anteilen von wenigstens einem Stoff ausgewählt aus der Gruppe der Amine, Ethanolamine, Ammonium-, Molybdän-, Cer-, Zirkonium-, Titan-, Barium- und Silizium-Salze. Hierbei kann der Wasserdampf zur Vermeidung einer vorzeitigen Hydrolyse und/oder Reaktion getrennt von weiteren Stoffen auf die Profiloberfläche geleitet werden.

Die Stoffe in gasförmigem Zustand umfassen auch metallorganische Verbindungen, die wenigstens eines der Metalle Silizium, Titan oder Zirkonium enthalten. Andere metallorganische Verbindungen umfassen wenigstens einen Stoff ausgewählt aus der Gruppe der Metall-Alkoxyde, Metall-Diketonate, Metall-Carboxylate, Silane, Siloxane und Titanate.

Die Stoffe in der Form eines Aerosols umfassen bevorzugt einen Stoff ausgewählt aus der Gruppe der Amine, Ethanolamine, Ammonium-, Molybdän-, Cer-, Zirkonium-, Titan-, Barium- und Silizium-Salze. In gewissen Fällen kann es sich als vorteilhaft erweisen, die Stoffe mittels eines Trägergases, vorzugsweise mittels Stickstoff, auf die Profiloberfläche zu leiten.

Reaktive Gase, wie zum Beispiel Sauerstoff oder Ozon, können ebenfalls getrennt von weiteren Stoffen auf die Profiloberfläche geleitet werden.

Die Vorteilhaftigkeit des erfindungsgemässen Verfahrens ergibt sich aus den nachfolgend angeführten Beispielen.

### Beispiel 1

Aus einer Legierung AlMgSi 0.5 wurde auf einer Strangpresse mit einer Pressgeschwindigkeit von ca. 15 m/min ein Flachprofil mit den Abmessungen 2 x 8 mm hergestellt. Am Matrizenausgang wurde eine Temperatur von 520°C auf der Oberfläche des Profils gemessen. Unmittelbar nach dem Austritt des Profils aus der Matrizenöffnung wurde Wasserdampf mit einem Anteil von 0.1 Gew.-% Triethanolamin bei einer Temperatur von 120°C auf die Profiloberfläche geleitet. Nach erfolgter Abkühlung konnte auf der Profiloberfläche eine kompakte Oxidschicht mit einer Dicke von ca. 100 nm festgestellt werden. Die Schicht bietet einen idealen temporären Korrosionsschutz der Profile vor einer weiteren Verarbeitung.

### Beispiel 2

Aus einer Legierung AlMgSi 0.5 wurde auf einer Strangpresse mit einer Pressgeschwindigkeit von 12 m/min ein Hohlrundprofil mit einem Aussendurchmesser von 10 mm hergestellt. Nach dem Austritt des Profils aus der Matrizenöffnung wurde an der Profiloberfläche eine Temperatur von 530°C gemessen. Mittels eines Ultraschall-Verneblers wurde eine Mischung von Tetraethoxysilan und Stickstoff als Trägergas bei einer Temperatur von 140°C auf die Profiloberfläche geleitet. Die nach erfolgter Abkühlung des Profils an der Profiloberfläche festgestellte Schicht aus SiO₂ wies eine Dicke von 20 nm auf. Die erzeugte Schutzschicht ist ein idealer Haftgrund für eine Pulverbeschichtung. Die Schutzwirkung der SiO₂-Schicht entspricht etwa derjenigen einer konventionellen, durch Gelbchromatieren mit Cr(VI) hergestellten Haftgrundschicht.

Eine zur Durchführung des erfindungsgemässen Verfahrens im industriellen Massstab geeignete Strangpresse ergibt sich aus der nachfolgenden Beschreibung sowie anhand Zeichnung; diese zeigt schematisch in
- Fig. 1 eine Strangpresse mit einer Zufuhrleitung für Reagenzien;
- Fig. 2 ein Detail der Strangpresse von Fig. 1;
- Fig. 3 einen Schnitt durch Fig. 2 entlang deren Linie I-I.

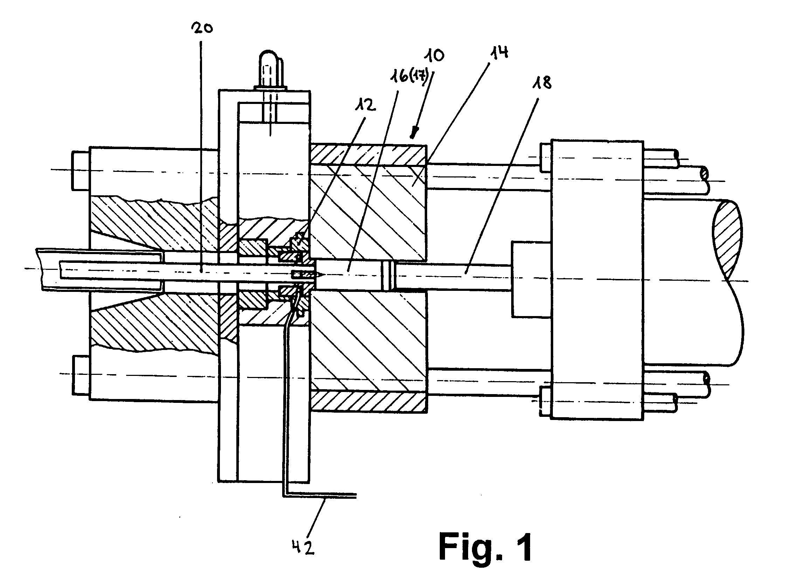

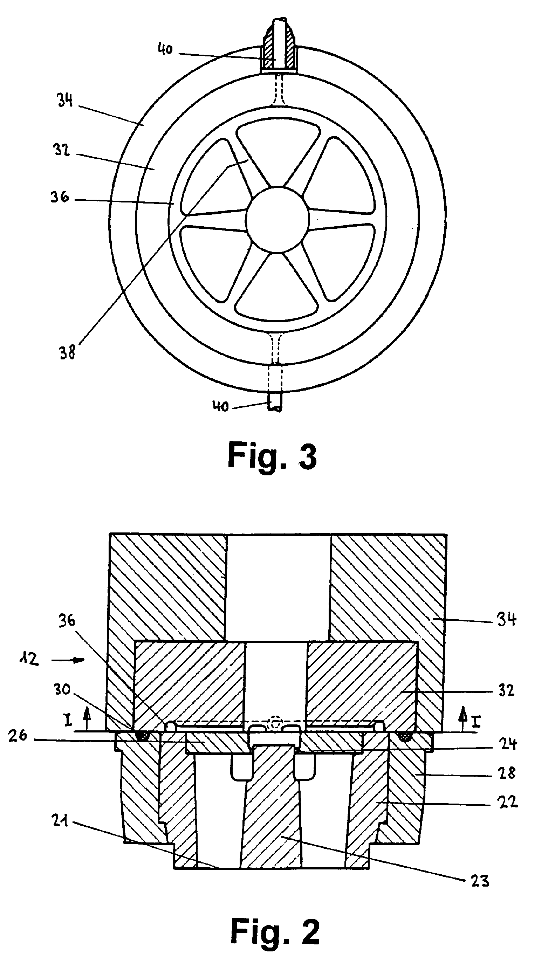

Eine in Fig. 1 dargestellte Strangpresse 10 weist ein in den Fig. 2 und 3 im Detail gezeigtes Presswerkzeug 12 auf. Dem Presswerkzeug 12 liegt ein Rezipient 14 mit einer zur Aufnahme eines Metallbolzens 17 ausgestalteten Rezipientenkammer 16 an. Ein Pressstempel 18 dient zum Verpressen eines in die Rezipientenkammer 16 eingeführten und bereits auf Presstemperatur angewärmten Metallbolzens 17 durch das Presswerkzeug 12 unter Bildung eines aus dem Presswerkzeug 12 austretenden Profils bzw. Profilstranges 20.

Das Presswerkzeug 12 umfasst eine Matrize 22, die zur Erzeugung eines Hohlprofils mit einem Dorn 23 ausgestattet ist. Während des Strangpressvorgangs tritt das Metall (17) unter dem Einfluss des Pressstempels 18 aus der Rezipientenkammer 16 in die Matrize 22 ein und verlässt diese bei einer formgebenden Öffnung 24 als Profilstrang 20.

Die Matrize 22 ist im vorliegenden Fall zweiteilig ausgebildet, da zur Bildung des äusseren Umfangs des Profilstrangs 20 ein Einsatz 26 vorgesehen ist. Die Matrize 22 mit dem Einsatz 26 ist in einen Halter 28 eingesetzt, der sich über einen Dichtungsring 30 auf einem Druckring 32 abstützt, der seinerseits in einem Druckringhalter 34 aufgenommen ist. Im Druckring 32 verläuft ringförmig eine kanalartige Ausnehmung 36, von der Kanäle 38 nahe bei der formgebenden Öffnung 24 der Matrize 22 münden. Die Ausnehmung 38 ist mit zwei Zuleitungen 40 zum Heranführen der zur Reaktion mit der Profiloberfläche in Kontakt tretenden Stoffe bzw. Reagenzien ausgestattet. Die Zufuhr der reaktiven Stoffe im gasförmigen Zustand oder in der Form von Aerosolen erfolgt mittels einer in Fig. 1 gezeigten Zufuhrleitung 42 über die Zuleitungen 40 in die kanalartige Ausnehmung 36 und weiter über die Kanäle 38 zur formgebenden Öffnung 24 der Matrize 22.

Im vorliegenden Beispiel werden die Stoffe bzw. Reagenzien direkt am Matrizenausgang auf die Oberfläche des Profilstranges 20 geleitet. Bei anderen Ausführungsformen kann die Zufuhr der reaktiven Stoffe auch über von der Matrize unabhängige Leitungssysteme und gegebenenfalls weiter von der Matrize entfernt erfolgen.

## Patentansprüche

1. Verfahren zur kontinuierlichen Behandlung der Oberfläche eines durch Verpressen eines vorgewärmten Bolzens (17) aus Aluminium oder aus einer Aluminiumlegierung durch die Matrizenöffnung (24) einer Strangpresse (10) hergestellten Profils(20),
**dadurch gekennzeichnet, dass**
zur Erzeugung einer als temporärer Korrosionsschutz und/oder als Haftgrund für weitere Beschichtungen dienenden Schicht nach dem Austritt des Profils (20) aus der Matrizenöffnung (24) wenigstens ein Stoff in gasförmigem Zustand oder in der Form eines Aerosols zur Reaktion auf und/oder mit der Profiloberfläche unter Bildung der Schicht auf die heisse, reaktive Profiloberfläche geleitet wird.

2. Verfahren nach Anspruch 1, **dadurch gekennzeichnet, dass** die Stoffe bei einer Profiltemperatur zwischen der Austrittstemperatur an der Matrizenöffnung (24) und 350°C, vorzugsweise zwischen der Austrittstemperatur an der Matrizenöffnung (24) und 450°C, auf die Profiloberfläche geleitet werden.

3. Verfahren nach Anspruch 2, **dadurch gekennzeichnet, dass** die Stoffe unmittelbar nach dem Austritt des Profils (20) aus der Matrizenöffnung (24) auf die Profiloberfläche geleitet werden.

4. Verfahren nach einem der Ansprüche 1 bis 3, **dadurch gekennzeichnet, dass** die Stoffe in gasförmigem Zustand Wasserdampf als Basis mit einem Anteil wenigstens eines Stoffes ausgewählt aus der Gruppe der Amine, Ethanolamine, Ammonium-, Molybdän-, Cer-, Zirkonium-, Titan-, Bariumund Silizium-Salze umfassen.

5. Verfahren nach Anspruch 4, **dadurch gekennzeichnet, dass** Wasserdampf getrennt von weiteren Stoffen auf die Profiloberfläche geleitet wird.

6. Verfahren nach einem der Ansprüche 1 bis 3, **dadurch gekennzeichnet, dass** die Stoffe in gasförmigem Zustand metallorganische Verbindungen umfassen.

7. Verfahren nach Anspruch 6, **dadurch gekennzeichnet, dass** die metallorganischen Verbindungen wenigstens eines der Metalle Silizium, Titan oder Zirkonium enthalten.

8. Verfahren nach Anspruch 6, **dadurch gekennzeichnet, dass** die metallorganischen Verbindungen wenigstens einen Stoff ausgewählt aus der Gruppe der Metall-Alkoxyde, Metall-Diketonate, Metall-Carboxylate, Silane, Siloxane und Titanate umfassen.

9. Verfahren nach einem der Ansprüche 1 bis 3, **dadurch gekennzeichnet, dass** die Stoffe in der Form eines Aerosols wenigstens einen Stoff ausgewählt aus der Gruppe der Amine, Ethanolamine, Ammonium-, Molybdän-, Cer-, Zirkonium-, Titan-, Barium- und Silizium-Salze umfassen.

10. Verfahren nach einem der Ansprüche 1 bis 9, **dadurch gekennzeichnet, dass** die Stoffe mittels eines Trägergases, vorzugsweise mittels Stickstoff, auf die Profiloberfläche geleitet werden.

11. Verfahren nach einem der Ansprüche 1 bis 3, **dadurch gekennzeichnet, dass** reaktive Gase, insbesondere Sauerstoff oder Ozon, getrennt von weiteren Stoffen auf die Profiloberfläche geleitet werden.
